# EUROPÄISCHE PATENTSCHRIFT

(11) **EP 3 210 081 B1**
(45) Veröffentlichungstag und Bekanntmachung des Hinweises auf die Patenterteilung: **13.06.2018**
(21) Anmeldenummer: 15784667.6
(22) Anmeldetag: 22.10.2015
(51) Int. Cl.: G03F 7/40, B41N 1/08

(54) **VERFAHREN ZUM EINBRENNEN VON BESCHICHTETEN DRUCKPLATTEN**
METHOD FOR BAKING COATED PRINTING PLATES
PROCÉDÉ POUR LA CUISSON DE PLAQUES D'IMPRESSION REVÊTUES

(30) Priorität: 22.10.2014 EP 14189964
(43) Veröffentlichungstag der Anmeldung: 30.08.2017
(73) Patentinhaber: Hydro Aluminium Rolled Products GmbH, 41515 Grevenbroich (DE)
(72) Erfinder: STEINHOFF, Gerd, 53125 Bonn (DE); NEUMANN, Stefan, 53225 Bonn (DE)
(74) Vertreter: Cohausz & Florack
(86) Internationale Anmeldenummer: PCT/EP2015/074510
(87) Internationale Veröffentlichungsnummer: WO 2016/062817

(56) Entgegenhaltungen:
- EP-A1- 2 712 942
- DE-A1- 4 134 161
- DE-B1- 2 648 438

## Beschreibung

Die Erfindung betrifft ein Verfahren zum Einbrennen einer Beschichtung einer Druckplatte, wobei die Druckplatte als Druckplattenträgermaterial Aluminium oder eine Aluminiumlegierung aufweist, bei welchem die Druckplatte auf eine Einbrenntemperatur erwärmt wird, über eine vordefinierte Dauer auf dieser Temperatur gehalten wird und anschließend abgekühlt wird. Daneben betrifft die Erfindung auch einen Durchlaufofen zur Durchführung des erfindungsgemäßen Verfahrens.

Offsetdruckplatten bestehen meistens aus einem dünnen Druckplattenträger aus Aluminiumblech mit einer Dicke von 0,1 bis 0,5 mm und einer auf dem Aluminium aufgebrachten Beschichtung, üblicherweise in Form einer lichtempfindlichen Schicht, welche je nach Anwendung durch thermisches Erhitzen eingebrannt werden kann. Die lichtempfindliche Schicht härtet dabei chemisch aus bzw. vernetzt chemisch durch die Temperatureinwirkung. Aus der deutschen Offenlegungsschrift DE 41 34 161 A1 ist ein Verfahren und eine Vorrichtung zum Einbrennen der Beschichtung auf einem Druckplattenträger, hier im weiteren als Einbrennen der Druckplatte bezeichnet, bekannt, bei welchem bzw. mit welcher Druckplatten durch eine kontinuierliche Zuführung zu einem als Durchlaufofen ausgestalteten Einbrennofen einem kontinuierlichen Einbrennvorgang unterzogen werden. In der genannten Offenlegungsschrift wird ausgeführt, dass die Druckplatten zur Verformung neigen, sofern eine ungleichmäßige Temperaturverteilung auf der Druckplatte erzeugt wird. Um dies zu verhindern werden mehrere Maßnahmen vorgeschlagen. Einerseits wird vorgeschlagen, die Druckplatte während des Erwärmens leicht zu verformen und über die eingebrachte Vorspannung eine zufällige Wellenbildung der Druckplatte zu vermeiden. Weiterhin soll durch die Strahlungsquelle über die Breite eine gleichmäßige Temperaturverteilung erzielt werden, indem die Strahlungsquelle quer zur Förderrichtung zu ihren Rändern hin eine größere Intensität aufweist. Schließlich werden auch sich verändernde Temperaturen der Strahlungsquellen sowie beheizte Fördermittel eingesetzt, um dieses Ziel zu erreichen. Ferner soll die Einlaufgeschwindigkeit der Druckplatte in den Ofenbereich sowie die Auslaufgeschwindigkeit aus dem Ofenbereich heraus gegenüber der Fördergeschwindigkeit im Ofenbereich erhöht sein.

Obwohl diverse Maßnahmen aus dem Stand der Technik bekannt sind, die Temperaturverteilung so homogen wie möglich zu gestalten, treten insbesondere bei großformatigen Druckplattenträgern Probleme mit Verformungen nach dem Einbrennvorgang auf. Trotz der im Stand der Technik vorgeschlagenen Maßnahmen sind die Verformungen beim kontinuierlichen Einbrennen so groß, dass Druckplattenträger zum Teil nicht mehr weiter verwendet werden können. Dies tritt insbesondere häufiger bei großflächigen Druckplattenträgern auf. Hier betragen die Wellenhöhe der Verformungen der Druckplatten zum Teil mehr als 6 mm. Insbesondere war bisher nicht bekannt, welche Temperaturgradienten der Metalltemperatur im Druckplattenträger tatsächlich zu einer starken Wellenbildung führen, so dass keine gezielte Vermeidung oder Verringerung der Wellenbildung erreicht wurde. In der Offenlegungsschrift DE 41 34 161 A1 wird deshalb auch von einer zufälligen Wellenbildung gesprochen. Zudem war nicht bekannt, ob die Eigenspannungen im Aluminiumträger oder die durch den Wärmebehandlungsprozess eingebrachten Spannungen maßgeblich für die Wellenbildung des eingebrannten Druckplattenträgers sind. Die in der deutschen Offenlegungsschrift DE 41 34 161 A1 erwähnten Maßnahmen sollen vornehmlich dem Erreichen einer gleichmäßigen Temperaturverteilung dienen.

Aufgabe der vorliegenden Erfindung ist es daher, ein Verfahren zum Einbrennen von Druckplatten bzw. von beschichteten Druckplattenträgern, insbesondere großformatigen Druckplatten vorzuschlagen, bei welchem die Verformungen nach dem Einbrennvorgang gezielt minimiert werden können. Daneben soll auch ein Durchlaufofen vorgeschlagen werden, welcher das erfindungsgemäße Verfahren ausführen kann.

Gemäß einer ersten Lehre der vorliegenden Erfindung wird die aufgezeigte Aufgabe dadurch gelöst, dass zumindest in einem Temperaturintervall zwischen 150°C und der Einbrenntemperatur, vorzugsweise 100°C und der Einbrenntemperatur die Temperaturdifferenzen der Metalltemperatur der Druckplatte gemessen entlang einer Linie in Längsrichtung der Druckplatte während des Aufheizens und während des Abkühlens maximal 40°C, maximal 30 °C oder maximal 20 °C auf einer Länge von 40 cm betragen und die Temperaturdifferenzen der Metalltemperatur der Druckplatte gemessen entlang einer Linie senkrecht zur Längsrichtung weniger als 10°C während des Aufheizens und während des Abkühlens betragen.

Es wurde erkannt, dass in einem Temperaturintervall zwischen 150°C und der Einbrenntemperatur bzw. 100°C und der Einbrenntemperatur sowohl der Aufheizprozess als auch der Abkühlprozess kritisch in Bezug auf Temperaturunterschiede der Metalltemperatur während des Einbrennens ist. Der Grund hierfür liegt in Bereichen der Druckplatte, die sich unterschiedlich stark elastisch und plastisch verformen. Zwar war bekannt, dass eine gleichmäßige Temperaturverteilung während des Aufheizens zu einer Verringerung der Verformung der Druckplatte führt, dass aber auch der Abkühlprozess eine sehr große Rolle spielt, war bisher nicht erkannt worden. Durch Simulationen wurde zudem erkannt, dass auch eine höhere Empfindlichkeit der Druckplatte auf Temperaturdifferenzen in Breitenrichtung als in Längsrichtung vorhanden ist. Die Längsrichtung entspricht vorliegend der Transportrichtung, da Druckplatten in Durchlauföfen üblicherweise entsprechend ausgerichtet transportiert werden. Die Querrichtung ist daher vorliegend immer senkrecht zur Transportrichtung. Durch erfindungsgemäßes Einhalten der Temperaturdifferenzen ist es damit möglich, die ungewollte Wellenbildung bei eingebrannten Druckplattenträgern deutlich zu reduzieren. Dies gilt vor allem für großformatige bzw. großflächige Druckplattenträger, die hier besonders empfindlich sind.

Vorzugsweise erfolgt das Einbrennen in einem Ofen diskontinuierlich, vorzugsweise in einem Batchofen oder in einem diskontinuierlich betriebenen Durchlaufofen. Der diskontinuierliche Ablauf des Einbrennvorgangs ist im Gegensatz zu der Lehre der deutschen Offenlegungsschrift DE 41 34 161 A1 vorteilhaft, da beim diskontinuierlichen Einbrennen der Druckplatte die Möglichkeit besteht, die gesamte Druckplatte nahezu gleichzeitig auf die Einbrenntemperatur zu erwärmen. Hierdurch werden die Temperaturdifferenzen auf der Druckplatte beim Erwärmen auf Einbrenntemperatur verringert. Die in DE 41 34 161 A1 beschriebenen Nachteile des Batchofens können umgangen werden, indem ein Durchlaufofen wie ein Batchofen diskontinuierlich betrieben wird. Hierzu wird die einzelne Druckplatte in den Durchlaufofen in sehr kurzer Zeit und vollständig in die Einbrennzone eingefahren. Im Durchlaufofen kann die Druckplatte in der Einbrennzone ortsfest verbleiben, bis der Einbrennvorgang beendet ist und sie aus der Einbrennzone vollständig heraustransportiert wird. Im Unterschied zur DE 41 34 161 A1 erfolgt das Einbringen der Druckplatte in die Einbrennzone mit einer Geschwindigkeit, so dass das Erwärmen der Druckplatte noch nicht signifikant begonnen hat, bevor die Druckplatte vollständig in der Einbrennzone angeordnet ist. Während im Stand der Technik etwa zwei Minuten für das kontinuierliche Zuführen der vollständigen Druckplatte in die Einbrennzone des Durchlaufofens benötigt werden, werden erfindungsgemäß innerhalb von maximal einer Minute, bevorzugt innerhalb von maximal 30 s oder 20 s, besonders bevorzugt innerhalb von maximal 10 s bzw. 5 s die Druckplatten in die Einbrennzone transportiert.

Gemäß einer Ausgestaltung wird hierzu die einzelne Druckplatte mit einer Geschwindigkeit von 25 mm/s bis 1000 mm/s in den Ofen komplett eingefahren, stationär eingebrannt und nach dem Einbrennprozess mit einer Geschwindigkeit von 25 mm/s bis 1000 mm/s aus dem Ofen ausgefahren. Die Größe der Einbrennzone des Durchlaufofens muss in diesem Fall mindestens der Größe der Druckplatte entsprechen. Nach dem Ausfahren aus dem Ofen erfolgt die Abkühlung gleichmäßig über Länge und Breite, so dass die erfindungsgemäßen Temperaturgradienten auf einfache Weise eingehalten werden können. Durch diese Vorgehensweise kann die unerwünschte Wellenbildung insofern aktiv minimiert werden. Alternativ kann auch ein Batchofen mit den bekannten Nachteilen zum gleichzeitigen Einbrennen mehrerer Druckplatten verwendet werden, dieser erreicht bei Einhaltung der erfindungsgemäßen Temperaturgradienten ebenfalls gute Planheitseigenschaften der Druckplatte.

Die Verformung der Druckplatte kann gemäß einer weiteren Ausgestaltung des Verfahrens dadurch weiter gesenkt werden, dass zumindest in einem Temperaturintervall zwischen 150°C und der Einbrenntemperatur, vorzugsweise 100°C und der Einbrenntemperatur die Temperaturdifferenz der Metalltemperatur der Druckplatte während des Aufheizens und während des Abkühlens gemessen entlang einer Linie senkrecht zur Längsrichtung maximal 5°C, bevorzugt maximal 2°C betragen. Hierdurch werden sowohl durch den Aufwärmprozess als auch durch das Abkühlen deutlich geringere Spannungen im Aluminiumblech der Druckplatte erzeugt und die Verformung wirkungsvoll reduziert bzw. unterdrückt.

Werden Druckplattenträger mit einer Breite von mindestens 300 mm und einer Länge von mindestens 450 mm, bevorzugt mit einer Breite von mindestens 1.000 mm und einer Länge von mindestens 1400 mm verwendet, können insbesondere großformatige Druckplattenträger, beispielsweise mit Breiten-Längenformaten von 1350 mm x 2800 mm oder 1600 mm x 2900 mm, mit eingebrannter Beschichtung bereitgestellt werden, die besonders geringe Verformungen nach dem Einbrennen zeigen.

Die Beschichtung der Druckplatte wird nach einer weiteren Ausgestaltung des Verfahrens dadurch ausreichend ausgehärtet und eingebrannt, dass die Einbrenntemperatur des Metalls der Druckplatte zwischen 220°C und 320°C mit einer Einbrenndauer zwischen 1 und 15 Minuten, bevorzugt 240°C bis 300°C mit einer Einbrenndauer von 2 bis 10 Minuten beträgt. Insbesondere ist bei der Auswahl der Einbrenntemperatur die Entfestigung des Druckplattenträgermaterials zu beachten, wobei insgesamt ein niedrigeres Temperaturniveau auch zu geringeren Verformungen der Druckplatte nach dem Einbrennen führt.

Gemäß einer weiteren Ausgestaltung des Verfahrens werden die Druckplatten während des Einbrennvorgangs über Transportmittel transportiert, wobei Transportmittel verwendet werden, welche einen Wärmetransport von der Druckplatte auf die Transportmittel verhindern oder stark reduzieren. Der Einfluss der Transportmittel auf die Temperaturverteilung der Druckplatte wird hierdurch stark reduziert, so dass eine homogene Temperaturverteilung der Druckplatte nicht durch den Transport der Druckplatte gestört wird. Vorstellbar sind beispielsweise Transportmittel, welche Materialien aufweisen, die eine besonders geringe Wärmeleitfähigkeit, also beispielsweise weniger als 1 W/mK z.B. temperaturfeste Kunststoffe oder Epoxidharze, aufweisen. Darüber hinaus ist vorstellbar, den Kontakt der Transportmittel mit den Druckplatten flächenmäßig zu minimieren, so dass über die verringerte Kontaktfläche sehr wenig Wärme von den Transportmitteln auf die Druckplatten bzw. von den Druckplatten auf die Transportmittel übertragen werden können. Andererseits besteht die Möglichkeit, wie auch aus dem Stand der Technik bekannt, beheizte Transportmittel zu verwenden, die idealerweise aber dann auch aus Materialien mit geringer Wärmeleitfähigkeit bestehen, so dass ein ungewollter Wärmeabtransport und damit eine inhomogene Temperaturverringerung an den Kontaktstellen mit den Transportmitteln verhindert wird.

Besonders bevorzugt wird die Abkühlung unter Verwendung von Abkühlmitteln, insbesondere unter Verwendung konvektiver Abkühlmedien derart durchgeführt, dass beim Abkühlen der gesamte Druckplattenträger gleichzeitig kontrolliert abgekühlt wird. Auch der Abkühlvorgang kann diskontinuierlich erfolgen, so dass die Abkühlung eines Druckplattenträgers nicht schrittweise den Druckplattenträger erfasst, sondern diesen immer vollflächig und gleichmäßig herunterkühlt. Beispielsweise kann dies über ein temperiertes, gasförmiges Kühlmedium erfolgen. Es ist dabei drauf zu achten, dass der Abkühlvorgang gleichmäßig die gesamte Druckplattenträgerlänge und -breite erfasst. Vorzugsweise werden die Druckplatten in der Auslaufzone von der Einbrenntemperatur auf unterhalb von maximal 100 °C, bevorzugt unterhalb von maximal 50 °C oder unterhalb von maximal als 30 °C abgekühlt.

Das Einfahren in einen "Waschautomaten", der ein flüssiges Medium verwendet, sollte daher auch erst nach Abkühlung auf unterhalb von maximal 100 °C, bevorzugt unterhalb maximal 50 °C, besonders bevorzugt unterhalb von maximal 30 °C erfolgen, um die Temperaturdifferenz bei der sehr schnellen Abkühlung durch das Waschmedium gering zu halten.

Erfindungsgemäß wird die oben aufgeführte Aufgabe gemäß einer weiteren Lehre für einen Durchlaufofen mit einer Einbrennzone zum Erwärmen und Halten einer Druckplatte auf einer Einbrenntemperatur und Mitteln zum Transportieren der einzubrennenden Druckplatte in die Einbrennzone und Mitteln zum Transportieren der Druckplatte aus der Einbrennzone, dadurch gelöst, dass die Einbrennzone des Durchlaufofens mindestens die Größe der Druckplatte aufweist, wobei die Mittel zum Transportieren der Druckplatte in die Einbrennzone und die Mittel zum Transportieren der Druckplatte aus der Einbrennzone zum diskontinuierlichen Transport der Druckplatte in die Einbrennzone und aus der Einbrennzone heraus ausgebildet sind.

Die Mittel zum Transportieren der Druckplatten in die Einbrennzone des Durchlaufofens und aus der Einbrennzone heraus stellen einen erfindungsgemäßen diskontinuierlichen Transport bereit, wenn diese die Druckplatte mit einer geeigneten Geschwindigkeit in die Einbrennzone transportieren können, so dass die Druckplatte noch nicht signifikant erwärmt wurde, bevor diese vollständig in der Einbrennzone angeordnet ist. Beispielsweise kann dies dadurch erreicht werden, dass die Druckplatte unter Verwendung der Transportmittel nach maximal einer Minute, nach maximal 30 s, besonders bevorzugt nach maximal 20 s oder maximal 10 s oder maximal 5 s vollständig in der Einbrennzone sich befindet und dort vollflächig erwärmt wird. Hierdurch können Temperaturdifferenzen beim Erwärmen deutlich verringert werden, da die gesamte Druckplatte gleichzeitig, nahezu stationär, erwärmt wird. Beim Abtransport aus der Einbrennzone werden Transportmittel benötigt, welche einen vollständigen Abtransport aus der Einbrennzone innerhalb von maximal 1 Minute, maximal 30 s oder bevorzugt innerhalb von maximal 20 s durchführen. Die geringe Dauer für das Einbringen der Druckplatten in die Einbrennzone sowie der Abtransport gewährleistet, dass, wie bereits ausgeführt, die Erwärmung und auch das Abkühlen nahezu vollflächig, also quasi stationär, erfolgen kann und damit geringere Temperaturdifferenzen bzw. -gradienten erreicht werden können.

Vorzugsweise sind gemäß einer Ausgestaltung des Durchlaufofens als Mittel zum Transportieren der Druckplatte in die Einbrennzone und heraus aus der Einbrennzone mindestens ein diskontinuierlich betreibbarer Drahtgurtförderer vorgesehen. Drahtgurtförderer bieten einerseits die Möglichkeit die Druckplatten auf einfache Weise zu transportieren, ohne dass ein großflächiger Kontakt zwischen Transportmittel und Druckplatte besteht, welcher zu Wärmeabfluss und damit zu Temperaturdifferenzen führen würde. Anders als im Stand der Technik bekannt, sind die Drahtgurtförderer diskontinuierlich betreibbar, d.h. die Fördergeschwindigkeit des Drahtgurtförderers ist abhängig von der Position der Druckplatte im Durchlaufofen veränderbar. Beispielsweise kann ein Drahtgurtförderer die Druckplatte mit hoher Geschwindigkeit in die Einbrennzone des Durchlaufofens befördern, sobald die Druckplatte in der Einbrennzone ist, die Geschwindigkeit auf Null oder nahe Null reduzieren und nach dem Einbrennen die Druckplatte mit hoher Geschwindigkeit aus der Einbrennzone abtransportieren.

Gemäß einer Ausgestaltung weisen die Mittel zum Transportieren der Druckplatten in die Einbrennzone und heraus aus der Einbrennzone des Durchlaufofens in den Kontaktbereichen mit den Druckplatten aufgrund der Geometrie eine verringerte Kontaktfläche und/oder ein Material mit einer geringen Wärmeleitfähigkeit auf. Ziel dieser Maßnahmen ist es, den Wärmeabtransport von der Druckplatte beim Transport zu verringern. Ein Material mit einer geringen Wärmeleitfähigkeit von beispielsweise weniger als 1 W/mK aber auch kleine Kontaktflächen können die Wärmeleitung weiter verringern und damit zur Erzielung geringer Temperaturdifferenzen in der Druckplatte beim Einbrennen und Abkühlen beitragen. Kleine Kontaktflächen werden beispielweise durch erhabene und gekrümmte Kontaktbereiche erreicht, so dass nur ein tangentialer Kontakt zwischen Transportmittel und Druckplatte zu Stande kommt. Prinzipiell können auch beheizte oder beheizbare Transportmittel eingesetzt werden, um die Temperatur der Transportmittel an die Druckplattentemperatur anzupassen und nur einen geringen Wärmeabtransport zu erlauben.

Ist eine Einlaufzone vorgesehen, in welcher die Druckplatten von Raumtemperatur auf maximal 150 °C, bevorzugt maximal 100 °C erwärmt werden und aus welcher die Druckplatten in die Einbrennzone transportiert werden kann, kann gemäß einer weiteren Ausgestaltung die Temperaturdifferenz zur Einbrennzone stufenweise verringert werden, so dass die Gefahr von großen Temperaturdifferenzen auf der Druckplatte beim Erwärmen auf Einbrenntemperatur verringert ist. Es hat sich außerdem gezeigt, dass die mechanischen Eigenschaften der Druckplatte bis zu diesen Temperaturen sich nicht so stark ändern. Damit treten unerwünschte Verformungen der Druckplatte in der Einlaufzone nahezu nicht auf.

Das Gleiche gilt auch, wenn gemäß einer weiteren Ausgestaltung des Durchlaufofens mindestens eine Auslaufzone vorgesehen ist, in welcher die Druckplatte von maximal der Einbrenntemperatur auf maximal 150 °C, bevorzugt maximal 100 °C oder maximal 60 °C abgekühlt wird.

Der Durchsatz des Durchlaufofens kann gemäß einer weiteren Ausgestaltung dadurch verbessert werden, dass die Einlaufzone und die Auslaufzone des Durchlaufofens als Puffer oder Magazin ausgebildet sind und eine Mehrzahl an zu erwärmenden oder abzukühlenden Druckplatten aufnehmen können.

Schließlich ist gemäß einer weiteren Ausgestaltung eine Spülvorrichtung vorgesehen, welche ausgangseitig der Auslaufzone vorgesehen ist und in welcher die Druckplatten mit einem flüssigen Spülmedium gespült und weiter abgekühlt werden. Über die Spülstation können die Druckplatten effizient und vollflächig, beispielsweise auf Raumtemperatur abgekühlt und gleichzeitig gereinigt werden.

Im Weiteren soll die Erfindung anhand von Ausführungsbeispielen in Verbindung mit der Zeichnung näher erläutert werden. Die Zeichnung zeigt in
- Fig. 1: in einer schematischen perspektivischen Ansicht einen Druckplattenträger,
- Fig. 2: eine schematische Schnittansicht eines Ausführungsbeispiels eines diskontinuierlich betriebenen Durchlaufofens,
- Fig. 3: ebenfalls eine schematische Schnittansicht eines zweiten Ausführungsbeispiels des erfindungsgemäßen Verfahrens mit einem Batchofen und
- Fig. 4: in einer schematischen Schnittansicht ein diskontinuierlich betriebener Durchlaufofen mit einer Ein- und Auslaufzone.

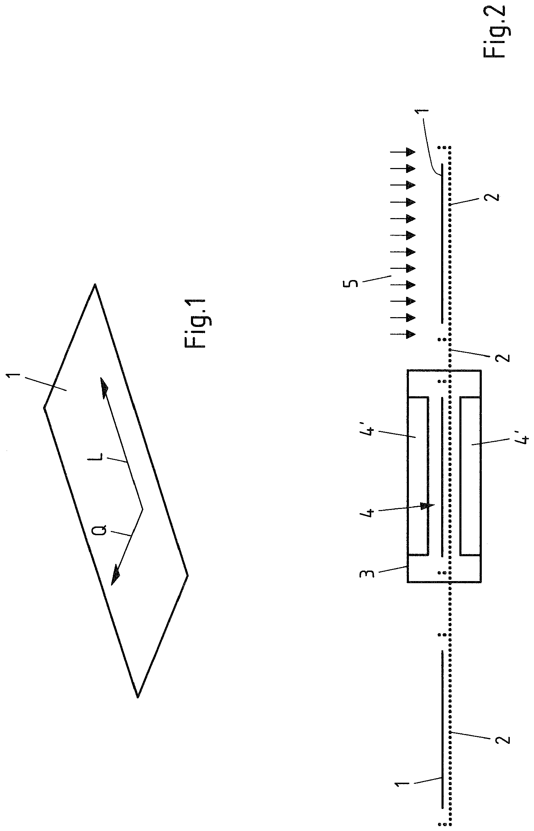

In Fig. 1 ist in einer schematischen, perspektivischen Ansicht eine Druckplatte 1 dargestellt, welche üblicherweise in einem rechteckigen Format vorliegt. Als Formate werden in der Regel mindestens 300 mm Breite und mindestens 1000 mm Länge verwendet. Großformatige Druckplatten 1 weisen vorzugsweise eine Breite von mindestens 1.000 mm und eine Länge von mindestens 2.000 mm auf. Gängige großformatige Druckplatten besitzen beispielsweise folgende Breiten-Längenverhältnisse: 1350 mm x 2800 mm oder 1600 mm x 2900 mm. Die Druckplatte 1 besteht dabei aus einem Aluminium- bzw. Aluminiumlegierungsblech als Druckplattenträger aufweisend eine Dicke von 0,1 mm bis 0,5 mm. Die Druckplatte 1 weist auf dem Träger eine Beschichtung, beispielsweise eine lichtempfindliche Beschichtung auf, welche eingebrannt werden soll.

Zur Untersuchung des Phänomens wurden zunächst Druckplatten 1 untersucht, in dem diese mit konventionellen Verfahren eingebrannt werden, wobei die Druckplatte zunächst in eine Mehrzahl an Messflächen eingeteilt wurde, auf welchen die Temperatur des Metalls der Druckplatte beispielsweise über Pyrometer gemessen wurde. Die Temperaturen wurden während des Einbrennvorgangs, beim Aufheizprozess und auch beim Abkühlprozess gemessen. Anschließend wurde die elastische und plastische Verformung der entsprechenden Bereiche der Druckplatte anhand der Temperaturverläufe simuliert und daraus die im Blech entstehenden Spannungen verteilt über die Fläche der Druckplatte ermittelt. Die daraus berechneten Verformungen wurden mit den tatsächlich entstandenen Verformungen verglichen, so dass Rückschlüsse auf das einzustellende Temperaturprofil der Druckplatte gezogen werden konnten.

Es wurde festgestellt, dass die Temperaturverteilung der Metalltemperatur der Druckplatte in Längsrichtung L Temperaturdifferenzen von maximal 40°C auf einer Strecke von 40 cm sowohl während des Aufheizens als auch während des Abkühlens aufweisen darf, um Verformungen zu begrenzen. Ein Überschreiten dieser Temperaturdifferenz führt zu stärkeren Verspannungen der Druckplatte nach dem Einbrennvorgang und damit zu einer irreversiblen Verformung der Druckplatte. Die Verformung führt zu unerwünscht großen Wellenbildung und Ausschuss an Druckplatten.

Gleichzeitig wurde festgestellt, dass die Druckplatte in Querrichtung Q, also senkrecht zur Längsrichtung deutlich empfindlicher auf Temperaturdifferenzen reagiert und Temperaturdifferenzen von weniger als 10°C senkrecht zur Längsrichtung eingehalten werden müssen, um nicht zu unerwünscht starker Wellenbildung zu führen. Bevorzugt beträgt quer zur Längsrichtung die maximale Temperaturdifferenz während des Einbrennen- bzw. Abkühlvorgangs 5°C, besonders bevorzugt maximal 2°C, so dass die Wellenbildung reduziert werden kann.

Um dies zu erreichen, kann das Einbrennen diskontinuierlich in einem Durchlaufofen durchgeführt werden. Fig. 2 zeigt hierzu beispielsweise einen diskontinuierlich betriebenen Durchlaufofen 3. Die Druckplatte 1 wird hierzu auf Transportmitteln 2 in die Einbrennzone 4 transportiert und erst dort erwärmt. Die Transportmittel 2 können beispielsweise als diskontinuierlich betreibbare Drahtgurtförderer ausgebildet sein, um die Druckplatte in die Einbrennzone zu transportieren. Die Einbrennzone 4 des Durchlaufofens ist mindestens so groß wie die Druckplatte 1 selbst. Ist die Druckplatte in der Einbrennzone des Durchlaufofens 3 angeordnet, stoppt der Drahtgurtförderer 2 den Transportprozess, bis die Druckplatte 1 eingebrannt ist. Der Drahtgurtförderer 2 kann zudem Materialien aufweisen, welche zumindest in den Kontaktbereichen mit der Druckplatte 1 eine besonders geringe Wärmeleitfähigkeit besitzen, um einen Wärmeabtransport bzw. ein ungleichmäßiges Erwärmen der Druckplatte 1 zu vermeiden. Insbesondere die Kontaktflächen der Transportmittel 2 mit der Druckplatte 1 weisen entsprechende Materialien auf. Beispielsweise können die Kontaktflächen aus temperaturbeständigem Epoxidharz mit einer Wärmeleitfähigkeit von weniger als 1 W/Km bestehen. Die Kontaktflächen der Transportmittel 2 können darüber hinaus im Querschnitt Radien aufweisen, so dass nur ein tangentialer Kontaktpunkt mit der Druckplatte 1 bereitgestellt wird. Der flächenmäßig sehr geringe Kontakt zur Druckplatte 1 wirkt sich ebenfalls positiv auf die Verringerung des Wärmeabtransports von der Druckplatte 1 aus.

Bevorzugt werden als Transportmittel Drahtgurtförderer 2 verwendet, welche über das Drahtgeflecht besonders geringe Kontaktflächen zur Druckplatte 1 gewährleisten. Die Drahtgurtförderer 2 befördern die Druckplatte 1 in die Einbrennzone 4 des Einbrennofens 3. Sobald die Druckplatte in der Einbrennzone 4 angeordnet ist, wird die Geschwindigkeit des Drahtgutförderers 2 auf Null reduziert und die Druckplatte 1 dann quasi stationär in der Einbrennzone 4 eingebrannt. Nach dem quasi stationären Einbrennen der Druckplatte wird die Druckplatte über den Drahtgurtförderer aus der Einbrennzone 4 mit hoher Geschwindigkeit abtransportiert und vollflächig abgekühlt. Durch entsprechend betreibbare Drahtgurtförderer 2 wird damit ein diskontinuierlicher Betrieb des Durchlaufofens 3 bzw. Einbrennofens 3 gewährleistet. Denkbar sind aber auch andere diskontinuierlich betreibbare Transportmittel einzusetzen.

Wie bereits ausgeführt, findet bevorzugt erst wenn die Druckplatte 1 in der Einbrennzone 4 des Durchlaufofens 3 positioniert ist, eine Erwärmung der Druckplatte 1 über die Erwärmungsmittel 4' statt. Beispielsweise kann eine Kombination aus Bestrahlung und konvektiver Erwärmung die Druckplatte besonders effektiv aber auch homogen erwärmen. Da in Querrichtung nur besonders geringe Temperaturdifferenzen tolerierbar sind, spielt eine gute Temperaturkontrolle des Einbrennvorgangs eine große Rolle. Die Positionierung der Druckplatte 1 in der Einbrennzone 4 des Durchlaufofens 3 erfolgt vorzugsweise innerhalb von maximal einer Minute, maximal 30 s oder bevorzugt innerhalb von maximal 20 s, besonders bevorzugt innerhalb von maximal 10 s bzw. 5 s. Die Transportmittel müssen an die Geometrie bzw. der Größe der Druckplatte 1 angepasste Transportgeschwindigkeiten gewährleisten. Der Durchlaufofen 3 wird aufgrund des Verbleibs der Druckplatte 1 für die Einbrenndauer im Durchlaufofen diskontinuierlich betrieben.

Die Einbrenntemperatur von 210°C bis 320°C bzw. 220°C bis 300°C wird für 1 bis 15 Minuten, bevorzugt 2 bis 10 Minuten gehalten und anschließend die Druckplatte 1 abgekühlt. Hierzu verbleibt bevorzugt die Druckplatte 1 auf dem Transportmittel, hier dem Drahtgurtförderer. Das Transportmittel wird dann gleichzeitig über ein Kühlmedium 5 mit der Druckplatte 1 konvektiv abgekühlt. Dieser Abkühlvorgang wird ebenfalls kontrolliert durchgeführt, so dass die gesamte Druckplatte gleichzeitig homogen abgekühlt wird. Es wurde erkannt, dass die einzuhaltenden Temperaturdifferenzen in Längsrichtung L von maximal 40°C auf 40 cm bzw. in Querrichtung Q, senkrecht zur Längsrichtung von 10°C, bevorzugt 5°C besonders bevorzugt 2°C betragen, andernfalls kann es zu unerwünscht starker Wellenbildung kommen. Durch diese Maßnahmen kann die Wellenhöhe nach dem Einbrennen der Druckplatte 1 auf deutlich unter 6mm gesenkt werden. Der Ausschuss an Druckplatten nach dem Einbrennen wird hierdurch deutlich verringert und zum Teil eine Verwendung der Druckplatten erst ermöglicht.

Um die erfindungsgemäßen Vorgaben für die Temperatur auf der Druckplatte einzuhalten, muss die Temperatur der Druckplatte zur Einstellung der Einbrennvorrichtung mindestens einmal im Prozess auf der gesamten Fläche gemessen werden. Hierzu kann eine Temperaturmessung mit Pyrometern im Prozess erfolgen. Bereits während des Einfahrens in den Einbrennofen bzw. Durchlaufofen 3 ist die Temperatur der Druckplatte zu messen. Die Erwärmungsmittel 4' sind dann bezüglich ihrer Heizleistung derart einzustellen, dass beim Erwärmen und Einbrennen die erfindungsgemäß geforderten Temperaturdifferenzen eingehalten werden. Das Gleiche wird auch für den Abkühlprozess und die Einstellung beispielsweise der Durchflussraten der Abkühlmedien durchgeführt. Die Einstellung der Erwärmungsmittel und gegebenenfalls auch der Abkühlmittel bezüglich der Erwärmungsleistung/Abkühlleistung pro Flächenelement ist sehr spezifisch und muss daher individuell an die vorhandenen Gegebenheiten angepasst werden. Unabhängig von den Parametern der jeweiligen Anlage zum Einbrennen der Druckplatten gewährleistet das erfindungsgemäße Verfahren eine deutliche Reduktion unerwünschter Verformungen der Druckplatte.

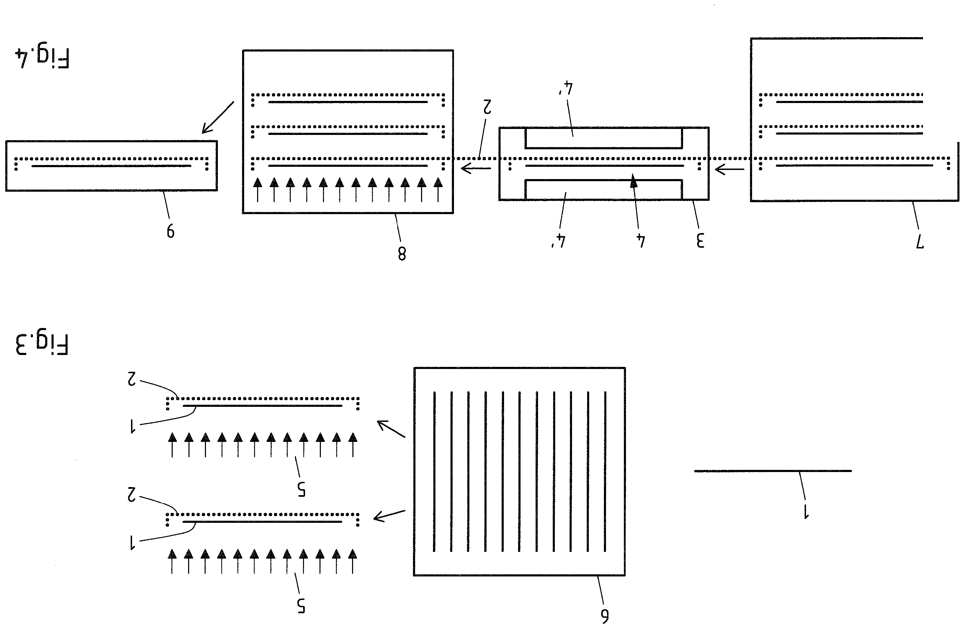

Fig. 3 zeigt schematisch ein weiteres Ausführungsbeispiel des erfindungsgemäßen Verfahrens unter Verwendung eines Batchofens 6, in welchen eine Mehrzahl an Druckplatten 1 eingebracht werden können. Durch die Verwendung des Batchofens 6 kann die Kapazität des Einbrennvorgangs erhöht werden und dennoch erreicht werden, dass alle Druckplatten 1, welche in dem Batchofen 6 angeordnet sind, sehr homogen und gleichmäßig erwärmt werden. Üblicherweise werden die Druckplatten 1 hierzu senkrecht im Batchofen 6 angeordnet. Anschließend erfolgt der Abkühlvorgang mit Abkühlmedien 5. Vorzugsweise werden dabei mehrere Druckplatten 1, angeordnet in Transportmitteln 2 gleichzeitig über ein Kühlmedium 5 abgekühlt.

Erfolgt der Aufwärmprozess und der Abkühlprozess der Druckplatte beim Einbrennen der Beschichtung in einem Batchofen unter Einhaltung der erfindungsgemäßen Temperaturdifferenzen, können die Verspannungen der Druckplatte nach dem Einbrennvorgang deutlich verringert und die Größe der unerwünschten Verformungen stark reduziert werden.

Fig. 4 zeigt eine Vorrichtung mit einem diskontinuierlich betreibbaren Durchlaufofen 3, welcher jeweils eine Einlaufzone 7 und eine Auslaufzone 9 aufweist. In der als Magazin bzw. Puffer ausgebildeten Einlaufzone 7 werden die Druckplatten 1 auf eine Temperatur von maximal 150 °C erwärmt und aus der Einlaufzone unter Verwendung von Drahtgurtförderern 2 in die Einbrennzone 4 befördert. Durch die Bevorratung in der Einlaufzone 7 kann der Aufwärmprozess langsam erfolgen. Außerdem steht eine vorgewärmte Druckplatte 1 bereits zur Verfügung, sobald eine Druckplatte die Einbrennzone 4 des Durchlaufofens 3 verlässt und in die Auslaufzone 8 transportiert wird. In der Auslaufzone 9, welche ebenfalls als Puffer bzw. Magazin ausgestaltet ist und eine Mehrzahl an Druckplatten 1 aufnehmen kann, können die Druckplatten 1 schonend abgekühlt werden, ohne dass die Temperaturdifferenzen überschritten werden. Anschließend wird die Druckplatte 1 in eine Spülvorrichtung 9 transportiert, in welcher die Druckplatte gereinigt und gleichzeitig weiter gekühlt wird.

## Patentansprüche

1. Verfahren zum Einbrennen einer Beschichtung eines Druckplattenträgers, wobei die Druckplatte als Trägermaterial Aluminium oder eine Aluminiumlegierung aufweist, bei welchem die Druckplatte auf eine Einbrenntemperatur erwärmt wird, über eine vordefinierte Dauer auf dieser Temperatur gehalten wird und anschließend abgekühlt wird,
**dadurch gekennzeichnet, dass**
zumindest in einem Temperaturintervall zwischen 150 °C und der Einbrenntemperatur, vorzugsweise 100 °C und der Einbrenntemperatur die Temperaturdifferenzen der Metalltemperatur der Druckplatte gemessen entlang einer Linie in Längsrichtung der Druckplatte während des Aufheizens und während des Abkühlens maximal 40 °C auf einer Länge von 40 cm betragen und die Temperaturdifferenzen der Metalltemperatur der Druckplatte entlang einer Linie senkrecht zur Längsrichtung gemessen weniger als 10 °C während des Aufheizens und während des Abkühlens betragen.

2. Verfahren nach Anspruch 1,
**dadurch gekennzeichnet, dass**
das Einbrennen in einem Ofen diskontinuierlich, vorzugsweise in einem Batchofen oder in einem diskontinuierlich betriebenen Durchlaufofen erfolgt.

3. Verfahren nach Anspruch 1 oder 2,
**dadurch gekennzeichnet, dass**
zumindest in einem Temperaturintervall zwischen 150 °C und der Einbrenntemperatur, vorzugsweise 100 °C und der Einbrenntemperatur die Temperaturdifferenzen der Metalltemperatur der Druckplatte während des Aufheizens und während des Abkühlens entlang einer Linie senkrecht zur Längsrichtung gemessen maximal 5 °C, bevorzugt maximal 2 °C betragen.

4. Verfahren nach einem der Ansprüche 1 bis 3,
**dadurch gekennzeichnet, dass**
Druckplattenträger mit einer Breite von mindestens 400 mm und einer Länge von mindestens 600 mm, bevorzugt mit einer Breite von mindestens 1000 mm und einer Länge von mindestens 2000 mm dem Einbrennvorgang unterzogen werden.

5. Verfahren nach einem der Ansprüche 1 bis 4,
**dadurch gekennzeichnet, dass**
die Einbrenntemperatur des Metalls der Druckplatte zwischen 220 °C und 320 °C mit einer Einbrenndauer zwischen 1 und 15 Minuten, bevorzugt 240 °C bis 300°C mit einer Einbrenndauer von 2 bis 10 Minuten beträgt.

6. Verfahren nach einem der Ansprüche 1 bis 5,
**dadurch gekennzeichnet, dass**
die Druckplatten unter Verwendung von Transportmitteln transportiert werden, welche einen Wärmeabtransport vom Druckplattenträger über die Transportmittel verhindern oder stark reduzieren.

7. Verfahren nach einem der Ansprüche 1 bis 6,
**dadurch gekennzeichnet, dass**
die Abkühlung unter Verwendung von Abkühlmitteln, insbesondere konvektiven Abkühlmedien derart durchgeführt wird, dass beim Abkühlen der gesamte Druckplattenträger gleichzeitig kontrolliert abgekühlt wird.

8. Durchlaufofen zur Durchführung eines Verfahrens nach einem der Ansprüche 1 bis 7 mit einer Einbrennzone zum Erwärmen und Halten einer Druckplatte auf einer Einbrenntemperatur und Mitteln zum Transportieren der einzubrennenden Druckplatte in die Einbrennzone und Mitteln zum Transportieren der Druckplatte aus der Einbrennzone,
**dadurch gekennzeichnet, dass**
die Einbrennzone (4) des Durchlaufofens (3) mindestens die Größe der Druckplatte (1) aufweist, die Mittel zum Transportieren (2) der Druckplatte (2) in die Einbrennzone (4) und die Mittel zum Transportieren (2) der Druckplatte (1) aus der Einbrennzone (4) zum diskontinuierlichen Transport der Druckplatte (1) in die Einbrennzone (4) und aus der Einbrennzone (4) heraus ausgebildet sind.

9. Durchlaufofen nach Anspruch 8,
**dadurch gekennzeichnet, dass**
als Mittel (2) zum Transportieren der Druckplatte (1) in die Einbrennzone (4) und heraus aus der Einbrennzone (4) des Durchlaufofens (3) diskontinuierlich betreibbare Drahtgurtförderer vorgesehen sind.

10. Durchlaufofen nach Anspruch 8 oder 9,
**dadurch gekennzeichnet, dass**
die Mittel (2) zum Transportieren der Druckplatte (1) in die und heraus aus der Einbrennzone (2) in den Kontaktbereichen mit den Druckplatten (1) aufgrund der Geometrie und/oder des verwendeten Materials der Kontaktbereiche eine sehr geringe Wärmeleitfähigkeit aufweisen.

11. Durchlaufofen nach einem der Ansprüche 8 bis 10,
**dadurch gekennzeichnet, dass**
eine Einlaufzone (7) vorgesehen ist, in welche die Druckplatten (1) von Raumtemperatur auf maximal 150 °C, bevorzugt maximal 100 °C erwärmt werden und aus welcher die Druckplatten (1) in die Einbrennzone transportiert werden kann.

12. Durchlaufofen nach einem der Ansprüche 8 bis 11,
**dadurch gekennzeichnet, dass**
eine Auslaufzone (8) vorgesehen ist, in welcher die Druckplatten (1) von der Einbrenntemperatur auf weniger als 100 °C, bevorzugt weniger als 50 °C oder weniger als 30 °C abgekühlt werden.

13. Durchlaufofen nach einem der Ansprüche 8 bis 12,
**dadurch gekennzeichnet, dass**
die Einlaufzone (7) und die Auslaufzone (8) als Puffer oder Magazin ausgebildet sind und eine Mehrzahl an zu erwärmenden oder abzukühlenden Druckplatten (1) aufnehmen können.

14. Durchlaufofen nach einem der Ansprüche 8 bis 13,
**dadurch gekennzeichnet, dass**
eine Spülvorrichtung (9) vorgesehen ist, welche ausgangseitig der Auslaufzone (8) vorgesehen ist und in welcher die Druckplatten (1) mit einem flüssigen Spülmedium gespült und weiter abgekühlt werden.

## Claims

1. Method for burning in a coating of a printing plate support, wherein the printing plate comprises aluminium or an aluminium alloy as the support material, in the case of which the printing plate is heated to a burning in temperature, maintained at this temperature for a predefined duration and subsequently cooled,
**characterised in that**
at least in a temperature range between 150°C and the burning in temperature, preferably 100°C and the burning in temperature, the temperature differences of the metal temperature of the printing plate measured along a line in the longitudinal direction of the printing plate during the heating and during the cooling are at most 40°C over a length of 40 cm and the temperature differences of the metal temperature of the printing plate measured along a line perpendicular to the longitudinal direction are less than 10°C during the heating and during the cooling.

2. Method according to Claim 1,
**characterised in that**
the burning in takes place in a furnace in a discontinuous manner, preferably in a batch furnace or in a continuous furnace operating in a discontinuous manner.

3. Method according to Claim 1 or 2,
**characterised in that**
at least in a temperature range between 150°C and the burning in temperature, preferably 100°C and the burning in temperature, the temperature differences of the metal temperature of the printing plate during the heating and during the cooling measured along a line perpendicular to the longitudinal direction are at most 5°C, preferably at most 2°C.

4. Method according to any one of Claims 1 to 3,
**characterised in that**
printing plate supports with a width of at least 400 mm and a length of at least 600 mm, preferably with a width of at least 1000 mm and a length of at least 2000 mm are subjected to the burning in process.

5. Method according to any one of Claims 1 to 4,
**characterised in that**
the burning in temperature of the metal of the printing plate is between 220°C and 320°C with a burning in duration of between 1 and 15 minutes, preferably 240°C to 300°C with a burning in duration of 2 to 10 minutes.

6. Method according to any one of Claims 1 to 5,
**characterised in that**
the printing plates are transported using transport means which prevent or sharply reduce heat dissipation from the printing plate support via the transport means.

7. Method according to any one of Claims 1 to 6,
**characterised in that**
the cooling is carried out using cooling means, in particular convective cooling media such that the entire printing plate support is simultaneously cooled in a controlled manner during the cooling.

8. Continuous furnace for carrying out a method according to any one of Claims 1 to 7 having a burning in area for heating and maintaining a printing plate at a burning in temperature and means for transporting the printing plate to be burned in into the burning in area and means for transporting the printing plate out of the burning in area,
**characterised in that**
the burning in area (4) of the continuous furnace (3) is at least the size of the printing plate (1), the means for transporting (2) the printing plate (2) into the burning in area (4) and the means for transporting (2) the printing plate (1) out of the burning in area (4) are designed for the discontinuous transport of the printing plate (1) into the burning in area (4) and out of the burning in area (4).

9. Continuous furnace according to Claim 8,
**characterised in that**
wire belt conveyors that can operate in a discontinuous manner are provided as the means (2) for transporting the printing plate (1) into the burning in area (4) and out of the burning in area (4) of the continuous furnace (3).

10. Continuous furnace according to Claim 8 or 9,
**characterised in that**
the means (2) for transporting the printing plate (1) into and out of the burning in area (2) have very low heat conductivity in the contact regions with the printing plates (1) due to the geometry and/or the materials of the contact regions used.

11. Continuous furnace according to any one of Claims 8 to 10,
**characterised in that**
an inlet area (7) is provided in which the printing plates (1) can be heated from room temperature to at most 150°C, preferably at most 100°C and out of which the printing plates (1) can be transported into the burning in area.

12. Continuous furnace according to any one of Claims 8 to 11,
**characterised in that**
an outlet area (8) is provided in which the printing plates (1) are cooled from the burning in temperature to less than 100°C, preferably less than 50°C or less than 30°C.

13. Continuous furnace according to any one of Claims 8 to 12,
**characterised in that**
the inlet area (7) and the outlet area (8) are designed as a buffer or store and can receive a plurality of printing plates (1) to be heated or to be cooled.

14. Continuous furnace according to any one of Claims 8 to 13,
**characterised in that**
a rinsing device (9) is provided which is provided on the outlet side of the outlet area (8) and in which the printing plates (1) are rinsed with a fluid rinsing medium and further cooled.

## Revendications

1. Procédé pour la cuisson d'un revêtement d'un support de plaque d'impression, où la plaque d'impression présente, comme matériau support, de l'aluminium ou un alliage d'aluminium, dans lequel la plaque d'impression est chauffée à une température de cuisson, est maintenue pendant une durée prédéfinie à cette température et est ensuite refroidie, **caractérisé en ce qu'**au moins dans un intervalle de température entre 150 °C et la température de cuisson, de préférence entre 100 °C et la température de cuisson, les différences de température de la température du métal de la plaque d'impression, mesurées le long d'une ligne dans la direction longitudinale de la plaque d'impression, pendant le chauffage et pendant le refroidissement, sont d'au maximum 40 °C sur une longueur de 40 cm et les différences de température de la température du métal de la plaque d'impression mesurées le long d'une ligne perpendiculaire à la direction longitudinale sont inférieures à 10 °C pendant le chauffage et pendant le refroidissement.

2. Procédé selon la revendication 1, **caractérisé en ce que** la cuisson a lieu dans un four de manière discontinue, de préférence dans une étuve discontinue, ou dans four à passage continu exploité en discontinu.

3. Procédé selon la revendication 1 ou 2, **caractérisé en ce qu'**au moins dans un intervalle de température entre 150 °C et la température de cuisson, de préférence entre 100 °C et la température de cuisson, les différences de température de la température du métal de la plaque d'impression pendant le chauffage et pendant le refroidissement, mesurées le long d'une ligne perpendiculaire à la direction longitudinale, sont d'au maximum 5 °C, de préférence au maximum de 2 °C.

4. Procédé selon l'une des revendications 1 à 3, **caractérisé en ce que** des supports de plaque d'impression avec une largeur d'au moins 400 mm et une longueur d'au moins 600 mm, de préférence avec une largeur d'au moins 1 000 mm et une longueur d'au moins 2 000 mm sont soumis au procédé de cuisson.

5. Procédé selon l'une des revendications 1 à 4, **caractérisé en ce que** la température de cuisson du métal de la plaque d'impression se situe entre 220 °C et 320 °C avec un temps de cuisson entre 1 et 15 minutes, de préférence entre 240 °C et 300 °C avec un temps de cuisson de 2 à 10 minutes.

6. Procédé selon l'une des revendications 1 à 5, **caractérisé en ce que** les plaques d'impression sont transportées en utilisant des moyens de transport, lesquels empêchent ou réduisent fortement l'évacuation de chaleur du support de plaque d'impression via les moyens de transport.

7. Procédé selon l'une des revendications 1 à 6, **caractérisé en ce que** le refroidissement est effectué en utilisant des agents de refroidissement, en particulier des agents de refroidissement convectifs de telle sorte que, lors du refroidissement, l'ensemble du support de plaque d'impression est refroidi simultanément de manière contrôlée.

8. Four à passage continu pour la mise en oeuvre d'un procédé selon l'une des revendications 1 à 7 avec une zone de cuisson pour chauffer et maintenir une plaque d'impression à une température de cuisson et des moyens permettant de transporter la plaque d'impression à cuire dans la zone de cuisson et des moyens permettant de transporter la plaque d'impression hors de la zone de cuisson, **caractérisé en ce que** la zone de cuisson (4) du four à passage continu (3) présente au moins la dimension de la plaque d'impression (1), les moyens permettant de transporter (2) la plaque d'impression (2) dans la zone de cuisson (4) et les moyens permettant de transporter (2) la plaque d'impression (1) hors de la zone de cuisson (4) sont conçus pour le transport en discontinu de la plaque d'impression (1) dans la zone d'impression (4) et hors de la zone d'impression (4).

9. Four à passage continu selon la revendication 8, **caractérisé en ce que** l'on prévoit en tant que moyens (2) permettant de transporter la plaque d'impression (1) dans la zone de cuisson (4) et hors de la zone de cuisson (4) du four à passage continu (3) des convoyeurs à ceintures en treillis pouvant être exploités de manière discontinue.

10. Four à passage continu selon la revendication 8 ou 9, **caractérisé en ce que** les moyens (2) permettant de transporter la plaque d'impression (1) dans et hors de la zone de cuisson (2) dans les zones de contact avec les plaques d'impression (1), étant donné la géométrie et/ou le matériau utilisé des zones de contact, présentent une très faible conductivité.

11. Four à passage continu selon l'une des revendications 8 à 10, **caractérisé en ce que** l'on prévoit une zone d'entrée (7), dans laquelle les plaques d'impression (1) sont chauffées à partir d'une température ambiante jusqu'à un maximum de 150 °C, de préférence à un maximum de 100 °C, et à partir de laquelle les plaques d'impression (1) peuvent être transportées dans la zone de cuisson.

12. Four à passage continu selon l'une des revendications 8 à 11, **caractérisé en ce que** l'on prévoit une zone de sortie (8), dans laquelle les plaques d'impression (1) sont refroidies à partir de la température de cuisson à une température inférieure à 100 °C, de préférence inférieure à 50 °C ou inférieure à 30 °C.

13. Four à passage continu selon l'une des revendications 8 à 12, **caractérisé en ce que** la zone d'entrée (7) et la zone de sortie (8) sont conçues en tant que tampon ou magasin et peuvent accueillir une multitude de plaques d'impression à réchauffer ou à refroidir (1).

14. Four à passage continu selon l'une des revendications 8 à 13, **caractérisé en ce que** l'on prévoit un dispositif de rinçage (9), lequel est prévu côté sortie de la zone de sortie (8) et dans lequel les plaques d'impression (1) sont rincées avec un agent de rinçage liquide et ensuite encore refroidies.
